# EUROPÄISCHE PATENTANMELDUNG

(11) **EP 2 360 720 A1**
(43) Veröffentlichungstag der Anmeldung: **24.08.2011**
(21) Anmeldenummer: 10154363.5
(22) Anmeldetag: 23.02.2010
(51) Int. Cl.: H01L 21/673

(54) **Vorrichtung zum Positionieren von mindestens zwei Gegenständen, Anordnungen, insbesondere Mehrschichtkörperanordnungen, Anlage zum Prozessieren, insbesondere zum Selenisieren, von Gegenständen, Verfahren zum Positionieren von mindestens zwei Gegenständen**

(71) Anmelder: Saint-Gobain Glass France, 92400 Courbevoie (FR)
(72) Erfinder: Palm, Jörg, 80797, München (DE); Fürfanger, Martin, 85643, Steinhöring (DE); Hartwich, Jessica, 82054, Sauerlach (DE); Jost, Stefan, 81543, München (DE)
(74) Vertreter: Lendvai, Tomas

(57) **Zusammenfassung**

Die Erfindung betrifft eine Vorrichtung zum Positionieren (30a bis 30g) von mindestens zwei Gegenständen, insbesondere von mindestens zwei Mehrschichtkörpern (40, 50), mit jeweils mindestens einer zu prozessierenden Oberfläche (44, 54), zum Prozessieren, insbesondere zum Selenisieren, der mindestens zwei Gegenstände in einer Prozessieranlage (10). Ferner sind vorgesehen Anordnungen, insbesondere Mehrschichtkörperanordnungen (28a bis 28g), eine Anlage (10) zum Prozessieren, insbesondere zum Selenisieren, von Gegenständen und entsprechende Verfahren zum Positionieren von mindestens zwei Gegenständen. Mit dem Gegenstand der Erfindung soll die thermische Prozessierung von Gegenständen, insbesondere von Mehrschichtkörpern, effizienter gestaltet werden. Somit lassen sich die Investitionskosten, insbesondere für entsprechende Anlagen, und damit auch die Produktionskosten senken.

## Beschreibung

Die Erfindung betrifft eine Vorrichtung zum Positionieren von mindestens zwei Gegenständen zur Anordnung in einer Prozessieranlage, Anordnungen, insbesondere Mehrschichtkörperanordnungen, eine Anlage zum Prozessieren, insbesondere zum Selenisieren, von Gegenständen sowie entsprechende Verfahren zum Positionieren und Anordnen von mindestens zwei Gegenständen.

Nachfolgend wird das Prozessieren von Mehrschichtkörpern beschrieben, z. B. von Substraten (z. B. Glassubstrate). Auch wenn der spezielle Begriff des "Substrates" verwendet wird, so beziehen sich die Ausführungen auch immer allgemein auf "Mehrschichtkörper". Als Substrat kann ein "nacktes", unbeschichtetes Substrat bezeichnet werden, ebenso wie ein beschichtetes, also auch ein Mehrschichtkörper.

Ein Mehrschichtkörper wird beispielsweise durch Aufbringen einer funktionellen Schicht auf eine Trägerschicht ausgebildet. Damit die Schichten oder zumindest die funktionelle Schicht gewünschte physikalische und/oder chemische Eigenschaften aufweisen, muss der Mehrschichtkörper bzw. müssen die Schichten ggf. einer Prozessierung unterzogen werden. Das Prozessieren kann beispielsweise als ein Temperieren bzw. Tempern in Gegenwart eines Prozessgases vorgesehen sein. Hierfür sind Anlagen vorgesehen, in der ein Mehrschichtkörper aufheizbar ist.

Die Mehrschichtkörper werden eingesetzt, um beispielsweise (insbesondere großflächige) Dünnschichthalbleiter herzustellen, beispielsweise Dünnschichtsolarzellen bzw. -module. Solarstromanlagen werden z. B. mit Solarmodulen auf der Basis von Chalkopyrit-Halbleitern (z. B. CuInSe₂, abgekürzt "CIS" oder Cu(In,Ga)(S,Se)₂, abgekürzt "CIGSSE") betrieben. Solche Dünnschichtsolarmodule weisen zumindest ein Substrat (z. B. Glas, Keramik, Metall- oder Kunststofffolie), eine erste Elektrode (z. B. Molybdän Mo oder ein Metallnitrid), eine Absorberschicht (z. B. CuInSe₂ oder allgemeiner (Ag,Cu)(In,Ga,AI)(Se,S)₂), eine Frontelektrode (z. B. ZnO oder SnO₂) und Verkapselungs- und Abdeckmaterialien (z. B. EVA/Glas oder PVB/Glas, wobei EVA für Ethylen-Vinylacetat und PVB für Polyvinylbutyral steht) als wesentliche Bestandteile auf. Weitere Schichten, wie z.B. Alkalibarrierenschichten zwischen Glas und Mo oder Pufferschichten zwischen Absorber und Fensterschicht können eingesetzt werden, um den Wirkungsgrad und/oder die Langzeitstabilität zu verbessern. Wesentlicher weiterer Bestandteil eines typischen Dünnschichtsolarmoduls ist die integrierte Serienverschaltung, die aus Einzelsolarzellen eine serienverschaltete Kette bildet und damit höhere Betriebsspannungen ermöglicht. Im Folgenden werden jeweils die chemischen Zeichen für bestimmte Elemente angegeben, beispielsweise "Mo" für Molybdän oder "Se" für Selen.

Labortechnische Versuche zeigen, dass die derzeit bekannten Herstellverfahren noch weit mehr verbessert und dass durch verfahrenstechnische Ansätze und Optimierungen wesentliche Kosteneinsparungen erreicht werden können. Derzeit gibt es verschiedene Verfahren zur Herstellung der Dünnschicht-Solarmodule auf der Basis von Chalkopyrit-Halbleitern. Bei einem bekannten Zweistufen-Verfahren werden in einem ersten Schritt die sogenannten Precursorschichten Cu(Ga), In und Se auf das kalte, bereits mit einer Mo-Dünnschicht versehene Substrat abgeschieden. Dies kann z. B. durch Sputtern, Elektrodeposition, Siebdruck, Verdampfungsprozesse oder chemische Gasphasenabscheidung erfolgen. In einem zweiten Schritt wird das dergestalt beschichtete Substrat in einer Prozesskammer (eines entsprechenden Ofens) unter Ausschluss von Luft erhitzt, indem ein vorgegebenes erprobtes Temperatur-Profil von Raumtemperatur bis ca. 600°C durchfahren wird. Während dieses Temperprozesses bildet sich aus den Precursorschichten in einer komplexen Phasenumwandlung der gewünschte Chalkopyrit-Halbleiter.

Dieser Prozess kann als In-Line-Prozessierung bezeichnet werden, z. B. In-Line-Selenisierung. Auch die Sulfurierung ist auf diesem Wege möglich. In-Line-Temperprozesse erfordern die sichere Beherrschung schneller CIS-Schichtbildungsprozesse sowie der ebenfalls beschleunigten Aufheiz- und Abkühlprozesse für z. B. große beschichtete Glasplatten. Dabei wird ein Schichtpaket bestehend z. B. aus Kupfer, Indium und Gallium sowie einer abschließenden Bedeckung aus elementarem Selen mit relativ hohen Aufheizraten von bis zu einigen K/s auf höhere Temperaturen gebracht, bei der die zuvor aufgetragenen Einzelkomponenten zur Halbleiterverbindung reagieren (schnelle thermische Prozessierung, Rapid Thermal Processing, RTP, von Schichtstapel-Vorläuferschichten, SEL-Precursor, Stacked Elemental Layer). Die gegenüber Ofenprozessen wesentlich kürzeren Reaktionszeiten erlauben nun eine Übertragung auf Durchlaufprozesse. Die Prozesskammer weist z. B. einen Tunnel auf bzw. bildet einen Tunnel aus, der beispielsweise mit Schleusen abdichtbar ist oder ist als eine abgeschlossene Prozesskammer vorgesehen. Die Prozesskammer wird mit Energiequellen, also z. B. matrixförmig angeordneten Strahlern zum Aufheizen bestrahlt.

Die großflächige Prozessierung von Cu(In,Ga)(S,Se)₂ (CIGSSE) Chalkopyrit-Halbleitern auf Glassubstraten, ausgehend von SEL-Precursorn erfordert also folgende grundsätzliche Voraussetzungen:
- schnelle Aufheizraten im Bereich einiger K/s,
- homogene Temperaturverteilung über das Glassubstrat (lateral) und über die SubstratDicke,
- Gewährleistung eines ausreichend hohen, kontrollierbaren und reproduzierbaren Partialdrucks der Chalkogenelemente (Se und/oder S) während des RTPs (Vermeidung von Se- und/oder S-Verlusten bzw. sonstigen aufgebrachten Elementen),
- kontrollierte Prozessgas-Zufuhr (z. B. H₂, N₂, Ar, H₂S, H₂Se, S-Gas, Se-Gas),
- Maximal-Temperaturen oberhalb von 500°C.

Die großtechnischen In-Line-Verfahren sind prozess- und anlagentechnisch sehr komplex. Dies führt dazu, dass die Investitionskosten für diesen Prozessschritt einen nicht unwesentlichen Anteil an den gesamten Investitionskosten einer Solarfabrik einnehmen.

Aufgabe der Erfindung ist es daher, die thermische Prozessierung von Gegenständen, insbesondere von Mehrschichtkörpern, effizienter zu gestalten und so die Investitionskosten, insbesondere für entsprechende Prozessieranlagen, und damit auch die Produktionskosten zu senken.

Diese Aufgabe wird durch eine Vorrichtung zum Positionieren von mindestens zwei Gegenständen nach Anspruch 1, Anordnungen nach den Ansprüchen 15 und 16, eine Anlage zum Prozessieren nach Anspruch 16 und durch entsprechende Verfahren zum Positionieren nach den Ansprüchen 19 und 20 gelöst.

Insbesondere wird die Aufgabe vorrichtungsmäßig durch eine Vorrichtung zum Positionieren von mindestens zwei Gegenständen, insbesondere von mindestens zwei Mehrschichtkörpern mit jeweils mindestens einer zu prozessierenden Oberfläche gelöst, wobei die Vorrichtung zur Aufnahme der mindestens zwei Gegenstände, insbesondere Mehrschichtkörper, derart ausgebildet ist, dass sich die Gegenstände, insbesondere Mehrschichtkörper, gegenüberliegen und die zu prozessierenden Oberflächen voneinander abgewandt sind. Damit sind die mindestens zwei Gegenstände als eine Mehrschichtkörperanordnung in einer Prozessieranlage prozessierbar, insbesondere selenisierbar.

Hierbei können die Mehrschichtkörper einen gewissen Abstand zueinander aufweisen, ggf. können die zu prozessierenden Oberflächen, insbesondere die untere aber auch unmittelbar auf einer geeigneten Stelle (z. B. Kammerboden) aufliegen.

Ein wesentlicher Punkt der Erfindung liegt darin, zwei Mehrschichtkörper, z. B. Glassubstrate mit Precursor-Beschichtung, gleichzeitig prozessieren zu können (Dual-Substrate Back-to-Back RTP), da sie durch die Vorrichtung zum Positionieren (auch Stützvorrichtung) entsprechend gelagert oder gestützt sind. Beide Substrate sind mit den Precursor-Elementen, z. B. Cu, Ga, In, Se, Na, beschichtet, wobei diese beschichteten, zu prozessierenden Oberflächen voneinander abgewandt angeordnet sind. Bei Beibehaltung der Prozesszeit führt dies zu verdoppeltem Anlagen-Durchsatz bei nahezu konstanter Anlagen-Crrundfläche und vergleichbarem Anlagen-Investitionsvolumen. Das heißt, das Anlagen-Design kann im Wesentlichen beibehalten werden.

Die zu prozessierenden Mehrschichtkörper weisen, wie bereits oben beschrieben, bereits erste Beschichtungen auf (Precursor). Auf diese Beschichtungen werden weitere Elemente abgeschieden und/oder es finden Umwandlungen in den Beschichtungen statt, um den Precursor zum gewünschten Halbleiter überzuführen. Die zu prozessierenden Oberflächen sind daher im Folgenden ganz allgemein als "Beschichtung", als "beschichtete Oberflächen", als "beschichtete Seite" oder eben als "zu prozessierende Oberflächen" etc. bezeichnet.

Die beschichteten Flächen weisen in Richtung der Energiequellen, daher sind höhere Aufheizraten und im Allgemeinen eine schnellere und direktere Temperaturmessung und damit -steuerung bzw. -regelung für die Schicht möglich. Die erreichbaren Wirkungsgrade bei der Prozessierung können damit erhöht werden, gleichzeitig lassen sich die Prozesszeiten senken.

Die Erfindung ist nicht nur auf Chalkopyrit-Halbleiter bezogen, sondern auch auf sämtliche Anwendungen von funktionalen Dünnschichten auf Substraten (z. B. CdTe-Halbleiter und verwandte Halbleiter neben den Chalkopyrit-Halbleitern).

In einer bevorzugten Ausführungsform ist die Vorrichtung (und damit schließlich die Mehrschichtkörperanordnung) in einer Prozesskammer oder einem Prozesstunnel der Prozessieranlage mit einem Kammerraum (oder Tunnelraum) und/oder in einer Einrichtung zum Ausbilden eines reduzierten Kammerraums und/oder auf oder an einem Tragelement zum Transportieren der Mehrschichtkörperanordnung mittels einer Transportvorrichtung in die Prozessieranlage (d. h. in die Prozesskammer oder den -tunnel) und aus dieser heraus, oder an einer sonstigen dafür geeigneten bzw. dafür vorgesehenen Stelle anordenbar oder angeordnet ("anordenbar" kann auch als "vorsehbar" verstanden werden). Die Vorrichtung ist also z. B. derart ausgebildet, dass sie außerhalb der Prozessieranlage zur Aufnahme der Mehrschichtkörper angeordnet werden kann, um sie schließlich in die Kammer oder den Tunnel einzufahren. Hierfür ist beispielsweise die Transportvorrichtung vorgesehen, die die Mehrschichtkörperanordnung bewegt und in die Anlage und auch wieder aus dieser heraus transportiert. Die Vorrichtung ist hierfür vorzugsweise derart ausgebildet, dass sie mit der Transportvorrichtung auf dem Tragelement (einem Carrier, eine Art Transporteinrichtung, wie z. B eine Transportplatte) transportierbar ist. Auch der Carrier allein kann die Transportvorrichtung ausbilden. Die Mehrschichtkörperanordnung kann auch manuell in die Anlage eingebracht oder direkt in dieser zusammengebaut werden.

Um möglichst wenig Prozessgas zu verbrauchen, ist es zweckmäßig, den Kammerraum zu reduzieren und einen expliziten Prozessraum zu schaffen. Zwischen den Substraten und den Energiequellen können daher mindestens teiltransparente Scheiben (z. B. aus Glaskeramik) oder für die gewählte Energiequelle hoch absorbierende Scheiben, die als sekundäre Energiequelle bzw. als Energietransmitter fungieren, angeordnet sein, die einen definierten Prozessraum bilden, um im Heizprozess das Abdampfen von flüchtigen Komponenten zu reduzieren bzw. zu minimieren. In bestimmten Phasen des Prozesses können in diesen Prozessraum zusätzliche Prozessgase (z. B. H₂, N₂, Ar, H₂S, H₂Se, S-Gas, Se-Gas und/oder andere) eingeführt werden. Dies kann mit der oben beschriebenen Einrichtung zum Ausbilden eines reduzierten Kammerraums realisiert werden, z. B. einer Prozessbox oder einer Prozesshaube. Die Vorrichtung zum Positionieren ist derart ausgebildet, dass sie in der Prozessbox oder Prozesshaube anordenbar oder angeordnet ist.

Im RTP-Prozess können z. B. die Prozessgase H₂, N₂, Ar, H₂S, H₂Se, S-Gas, Se-Gas eingesetzt und zu gezielten Prozesszeiten ins Ofeninnere also in den Kammerraum bzw. ins Innere der Prozessbox eingeleitet werden. Möglich ist es also auch, den Sulfurisierungsprozess mit gasförmigem Schwefel (S) bzw. den Selenisierungsprozess mit gasförmigem Selen (Se) durchzuführen.

Eine ausreichende Se-Menge ist nötig, um eine vollständige Selenisierung des metallischen (z. B.) CuInGa-Precursors zu gewährleisten. Se-Verlust würde zu einer unvollständigen Umwandlung des Precursors zum Chalkopyrit-Halbleiter und somit zu deutlichem Leistungsverlust des Solarmoduls führen. Die Gewährleistung einer ausreichenden Se-Menge erfolgt z. B. durch den Einsatz der Prozessbox. Entsprechendes gilt für andere derartige Prozesse.

Prozessboxen lassen sich offen oder auch geschlossen gestalten. Bei offenen Boxen sind z. B. keine oder nur teilweise Seitenwände vorhanden. Bei geschlossenen Boxen umschließen ein Bodenelement, ein Deckelelement und Seitenwände den Prozessraum im Wesentlichen vollständig. Prozesshauben sind üblicherweise auf den Boden der Prozesskammer auflegbar und zum stationären Verbleib in der Kammer vorgesehen.

Vorzugsweise bildet mindestens ein Teil der Vorrichtung zum Positionieren mindestens einen Teil der Prozessbox, insbesondere mindestens teilweise die Seitenwandelemente der Prozessbox aus. Somit ist auf einfache Weise ein Prozessbox herstellbar.

Ist eine Prozessbox zum Reduzieren des Kammerraums vorgesehen, so kann die erfindungsgemäße Vorrichtung zum Positionieren unmittelbar in dieser angeordnet werden. Letztendlich lässt sich die Prozessbox dann mit der Mehrschichtkörperanordnung in die Prozessieranlage befördern (z. B. mittels des Carriers). Es ist auch möglich, die Mehrschichtkörperanordnung außerhalb der Anlage "zusammenzubauen" und erst dann in die Kammer einzubringen (z. B. mittels des ggf. beweglichen Carriers oder auch manuell). Das heißt, die Vorrichtung ist auf dem Carrier angeordnet, so dass sich die zusammengebaute Mehrschichtkörperanordnung mittels der Transportvorrichtung und/oder mittels des Carriers in die Anlage einfahren lässt. Die Prozesskammer der Anlage könnte dann z. B. die oben beschriebene Prozesshaube aufweisen, so dass mit einem reduzierten Kammerraum gearbeitet werden kann.

Die Einrichtung zur Ausbildung eines reduzierten Kammerraums und/oder die Vorrichtung zum Positionieren (die ggf. zum Teil die Einrichtung mit ausbildet) sind vorzugsweise derart ausgebildet, dass der aus Bodenelement und unterem Substrat bzw. Deckelelement und oberem Substrat gebildete (reduzierte) Prozessraum ein geeignetes Volumen hat: er darf nicht zu groß sein, damit nicht zu viel Chalcogenmenge (Se oder S) oder ggf. auch flüchtige Reaktionsprodukte verdampfen (abzuschätzen aus dem Gleichgewichts-Dampfdruck bei Prozesstemperatur), aber auch nicht zu klein, damit bei temporären Verbiegungen des Substrats im Aufheizprozess die beschichteten Seiten des Substrats nicht die gegenüberliegende Gegenplatte berühren (insbesondere bei der oberen Scheibe). Der Abstand zwischen Gegenplatte und Substrat sollte z. B. jeweils etwa zwischen 1 und 20 mm betragen. Grundsätzlich wäre jedoch auch unmittelbarer Kontakt zwischen Substrat und Gegenplatte möglich.

Damit die Strahlung der Energiequellen bis zu den zu prozessierenden Oberflächen durchdringen kann, sind (wie bereits oben angedeutet) die dazwischenliegenden Elemente, wie z. B. Bodenelement und Deckelelement der Prozessbox oder auch die Prozesshaube mindestens teiltransparent ausgebildet, je nach Ausgestaltung der Energiequellen. Zwischen den Substraten und den Strahlungsquellen müssen also (sofern die Energiequellen-Anordnung diese erfordert) etwaige Elemente als teiltransparente oder transparente Scheiben (z. B. aus Glaskeramik) oder als für die gewählte Energiequelle hoch absorbierende Scheiben, die als sekundäre Energiequelle bzw. als Energietransmitter fungieren, ausgebildet sein. Sind die Quellen z. B. im Inneren der Prozesskammer (ggf. auch im Inneren der Prozessbox oder -haube) angeordnet, und liegt auch die Mehrschichtkörperanordnung z. B. in der Prozesskammer, so kann die Kammerwandung (Seitenwände, Deckel und/oder Boden) auch nicht-transparent ausgebildet sein.

Als Material von Boden- und Deckelelement oder der Prozesshaube kann bzw. können z. B. Glaskeramik, andere Keramiken, Graphit, Metalle und hochschmelzende Gläser (Auswahl) vorgesehen sein. Auch Siliziumcarbid kann hierfür vorgesehen sein. Auch der Carrier sollte mindestens teilweise aus teiltransparentem oder hoch absorbierendem Material ausgebildet sein, da er während des Prozessierens in der Anlage verbleiben kann.

In einer vorteilhaften Ausführungsform ist die Vorrichtung derart ausgebildet, dass die Mehrschichtkörper im Gebrauch sandwichförmig übereinanderliegend angeordnet sind und so einen unteren Mehrschichtkörper und einen oberen Mehrschichtkörper der Mehrschichtkörperanordnung ausbilden. Damit ist die Beschichtung bzw. die zu prozessierende Oberfläche obenliegend auf dem oberen Substrat und untenliegend auf dem unteren Substrat (Back-to-Back-Anordnung) angeordnet.

In diesem Falle können die Substrate auf einfache Weise in der Kammer oder der Einrichtung zum Ausbilden eines reduzierten Kammerraums gelagert bzw. positioniert oder angeordnet werden, nämlich mit den voneinander abgewandten zu prozessierenden Oberflächen aufeinanderliegend. Das heißt, die Rückseiten der Substrate liegen aufeinander.

Vorzugsweise weist die Vorrichtung mindestens ein Beabstandungselement auf, wobei das Beabstandungselement derart mindestens teilweise zwischen den zwei Mehrschichtkörpern anordenbar ist, dass diese beabstandet voneinander positionierbar bzw. anordenbar sind. Ein Beabstandungselement erleichtert das spätere Abheben des oberen Substrats vom unteren (z. B. Adhäsion).

In einer vorteilhaften Ausgestaltung der Erfindung weist die Vorrichtung mindestens ein erstes Auflageelement auf, das folgendermaßen anordenbar ist oder angeordnet ist: auf einem Kammerboden und/oder an Kammerseitenwänden der Pozesskammer und/oder auf dem Bodenelement und/oder an den Seitenwandelementen der Prozessbox und/oder auf oder an dem Tragelement zum Transportieren der Mehrschichtkörperanordnung mittels der Transporteinrichtung in die Prozessieranlage und aus dieser heraus oder an einer sonstigen dafür vorgesehenen Stelle. Das erste Auflageelement ist dabei derart ausgebildet, dass der untere Mehrschichtkörper vorzugsweise an dessen Kantenbereichen mindestens teilweise an dem ersten Auflageelement anordenbar, insbesondere auf das Auflageelement auflegbar ist.

Vorteilhafterweise weist die erfindungsgemäße Vorrichtung mindestens ein zweites Auflageelement auf, das folgendermaßen anordenbar ist oder angeordnet ist:
auf dem Kammerboden und/oder an den Kammerseitenwänden der Pozesskammer und/oder auf dem Bodenelement und/oder an den Seitenwandelementen der Prozessbox und/oder auf oder an dem ersten Auflageelement und/oder auf oder an dem Tragelement zum Transportieren der Mehrschichtkörperanordnung mittels der Transportvorrichtung in die Prozessieranlage und aus dieser heraus oder an einer sonstigen dafür vorgesehenen Stelle.
Das zweite Auflageelement ist derart ausgebildet, dass der obere Mehrschichtkörper vorzugsweise an dessen Kantenbereichen mindestens teilweise an dem zweiten Auflageelement anordenbar, insbesondere auf das Auflageelement auflegbar ist.

Die beiden Mehrschichtkörper sind somit im Wesentlichen getrennt voneinander lagerbar. Im Falle einer vollständig getrennten Lagerung lassen sich die einzelnen Mehrschichtkörper unabhängig voneinander positionieren (ein späteres Entnehmen der prozessierten Substrate wird damit erleichtert).

Insbesondere das erste oder untere Auflageelement kann selbst die Funktion des Carriers übernehmen und z. B. mit einem Rollenantrieb befördert werden.

Es ist in einer vorteilhaften Ausführungsform der Erfindung vorgesehen, dass das erste Auflageelement und/oder das zweite Auflageelement jeweils als ein Rahmenelement, vorzugsweise als ein die Konturen der Mehrschichtkörper nachbildend rechteckförmig oder quadratisch ausgebildetes Rahmenelement vorgesehen sind, so dass die Mehrschichtkörper vorzugsweise an deren Kantenbereichen mindestens teilweise an dem jeweiligen Rahmenelement anordenbar, insbesondere auf das Rahmenelement auflegbar sind.

Die Rahmenelemente ermöglichen einen möglichst geringen Kontakt der Mehrschichtkörper, also z. B. der Substrate, mit diesem (also mit dem Rahmenelement), um die zu prozessierenden Oberflächen möglichst frei zu halten.

Vorzugsweise sind erste Auflageelement und/oder das zweite Auflageelement jeweils als zwei, in einer Erstreckungsebene der Mehrschichtkörper sich gegenüberliegende Rahmenleistenelemente ausgebildet, so dass die Mehrschichtkörper vorzugsweise an deren Kantenbereichen, z. B. an deren Längsseiten, mindestens teilweise an den Rahmenleistenelementen anordenbar, insbesondere auf die Rahmenleistenelemente auflegbar sind. Die Leisten sind zur Lagerung ausreichend, gleichzeitig werden die zu prozessierenden Oberflächen noch weniger von etwaigen Auflagebereichen beeinflusst. Die Mehrschichtkörper können natürlich auch über deren Querseiten gelagert werden.

Das Auflageelement (insbesondere das untere) ist vorzugsweise derart ausgebildet (z. B. seitlich offen), dass während des Prozesses von der Seite noch ein Prozessgas z. B. von einer externen Gasquelle eingeführt werden kann. In diesem Fall sollte der Abstand zwischen Substrat und Gegenplatte ebenfalls groß genug sein, um die Verteilung von Prozessgasen (z. B. H₂, N₂, Ar, H₂S, H₂Se, S-Gas, Se-Gas) zu ermöglichen.

Gegebenenfalls ließen sich mindestens ein explizites Gaszufuhrelement und/oder Gasabfuhrelement zum Zuführen und/oder Abführen des Prozessgases in den und/oder aus dem Prozessraum vorsehen, das z. B. in dem Rahmenelement angeordnet ist. Das Rahmenelement könnte also Öffnungen aufweisen, um die Prozessgaszirkulation zu ermöglichen.

An sich können die Gasverteiler auch anderweitig an der Kammer und/oder an der Prozessbox angeordnet werden. Wichtig ist es, ein im Wesentlichen homogenes Einleiten des Prozessgases von einer Gasquelle, z. B. einer externen Gasquelle, hin zu den Substraten (über die Prozesskammer oder den Prozesstunnel oder unter Umgehung der Prozesskammer oder des Prozesstunnels nur in eine ggf. vorhandene Prozessbox oder -haube) zu ermöglichen, so dass es zu einer möglichst laminaren Gasströmung über die Substratoberfläche von z. B. einer Längskante zur anderen kommt. Die Gaszufuhr kann an vorgegebenen Einlässen der Gasverteiler zu beliebigen Zeiten des Temperprofiles gesteuert werden. Verbrauchte Mengen des Prozessgases können so nachgeladen werden und/oder nicht mehr erwünschter überschüssiger (z. B.) Selendampf (und/oder sonstige Komponenten des Dampfes) kann aus der Reaktionskammer zum richtigen Zeitpunkt verdrängt werden.

Möglich ist es auch, die Rahmenleistenelemente derart auszubilden, dass sie sich jeweils um mindestens zwei sich diagonal gegenüberliegende Ecken der Mehrschichtkörperanordnung erstrecken. Die übrigen offenen Bereiche, die dann sowohl an den Längs- als auch an den Querseiten der Anordnung vorgesehen sind, dienen dem Gasaustausch.

Eine weitere Ausführungsform sieht vor, dass die Vorrichtung zum Positionieren ein Zwischenelement umfasst, das zwischen dem ersten Auflageelement und dem zweiten Auflageelement anordenbar ist, so dass das zweite Auflageelement auf dem ersten Auflageelement über das Zwischenelement lagerbar ist. Mit dem Baukastenprinzip können unterschiedliche Abstände zwischen den beiden Mehrschichtkörpern vorgesehen werden und so kann ggf. die Prozessgaszufuhr entsprechend gesteuert werden.

Eine vorteilhafte Ausgestaltung sieht vor, dass das erste Auflageelement und das zweite Auflageelement jeweils mindestens einen Auflagebereich aufweisen, an welchen der oder die Mehrschichtkörper anordenbar, insbesondere auf welchen der oder die Mehrschichtkörper auflegbar sind. Die expliziten Auflagebereiche sind vorzugsweise derart ausgelegt, dass die zu prozessierenden Oberflächen möglichst wenig durch die Lagerung beeinträchtigt werden. Bei den Rahmenelementen können die gesamten Leisten für die Auflage vorgesehen sein oder auch nur ein Teilbereich.

Beim Lagern der Substrate ist darauf zu achten, dass die beschichteten Seiten möglichst wenig berührt werden, um eine Kontamination durch Berühren oder die Störung der Prozessgasatmosphäre an der Kontaktfläche zu vermeiden (damit die Schichtqualität des entstehenden Absorbers nicht lokal oder integral beeinträchtigt wird). Diese Anforderung wird zum Teil dadurch erleichtert, dass z. B. 15 mm des Randbereichs von jeder Kante in einem späteren Prozessschritt sowieso entfernt werden und daher nicht zur aktiven Schicht gehören.

Während der RTP-Prozessierung muss ggf. mit einer Substratverbiegung gerechnet werden, da die Substrate ggf. quasi schwebend gelagert sind (je nach Auflageelement). Es ist vorstellbar dass es bei hohen Prozess-Temperaturen zu Durchbiegungen kommt, die sich nach der Prozessierung in Substratverbiegungen manifestieren.

Deshalb können das erste Auflageelement und/oder das zweite Auflageelement jeweils mindestens ein Querverbindungselement zum Verbinden von, in der Erstreckungsebene der Mehrschichtkörper sich gegenüberliegenden Bereichen des jeweiligen Rahmenelements oder von sich im Gebrauch gegenüberliegenden Rahmenleistenelementen aufweisen, so dass der oder die Mehrschichtkörper zur Vermeidung einer Durchbiegung zusätzlich abstützbar ist oder sind.

Die Querstreben dienen zugleich der Stabilisierung des Rahmens bzw. des Rahmenelements oder der Rahmenleistenelemente. Beim Design der Querstreben bzw. Querverbindungselemente ist auf eine minimale Breite zu achten, um eine Abschattung der Strahlung der (Heiz-)Strahler bzw. der Energiequellen zu minimieren.

Da das Querverbindungselement sich im Wesentlichen "quer" über die zu prozessierende Oberfläche ziehen kann, sollte der Kontakt zwischen Querverbindungselement und Oberfläche möglichst gering gehalten werden. Hierfür kann das Querverbindungselement mindestens ein erstes Abstützelement aufweisen, so dass die Mehrschichtkörper auf dem oder an dem Querverbindungselement über das Abstützelement auflegbar oder anlegbar sind, wobei das Abstützelement derart ausgebildet ist, dass es dieselbe Höhe wie das jeweilige mindestens eine Rahmenelement oder die Rahmenleistenelemente aufweist (planes Aufliegen der Substrate auf dem oder den Rahmenelement(en) und dem Abstützelement).

Bevorzugt ist mindestens ein zweites Abstützelement (der Vorrichtung zum Positionieren) am Kammerboden der Prozesskammer und/oder am Bodenelement der Prozessbox zum Abstützen der Mehrschichtkörperanordnung vorgesehen. Insbesondere die Anordnung am "unteren" Bereich der Mehrschichtkörperanordnung ist zweckmäßig, da hier möglicherweise (je nach Ausgestaltung der Vorrichtung zum Positionieren) die größte Last liegt.

Vorzugsweise ist das erste und/oder zweite Abstützelement (oder sind die Abstützelemente) als Punktstützenelement, vorzugsweise als Kugelelement ausgebildet. Somit ist eine möglichst kleine Auflagefläche oder auch Anlagefläche gewährleistet. Eine noch geringere Abschattung wird durch nadelförmige Auflagen erreicht.

In einer bevorzugten Ausgestaltung der Erfindung weist das jeweilige Rahmenelement und/oder Rahmenleistenelement mindestens zwei Abstützelemente derart auf, dass die Mehrschichtkörper auf den oder an den Abstützelementen auflegbar oder anlegbar sind. Das heißt, auch an dem Rahmenelement kann der Auflagebereich reduziert werden, wenn dieses mit den Abstützelementen ausgebildet ist.

Vorzugsweise sind das erste und/oder das zweite Auflageelement aus Graphit oder Quarzglas ausgebildet, auch Glaskeramik, andere Keramiken und hochschmelzende Gläser sind denkbar.

Das Rahmenmaterial sollte inert sein, beständig in korrosiver Umgebung (S-, Se-haltig) und mechanisch stabil. Aufgrund des direkten Kontaktes mit den Substraten sind auch die Wärmeleitfähigkeit und der thermische Ausdehnungskoeffizient zu betrachten, um laterale Inhomogenitäten der Temperaturverteilung auf dem Substrat weitestgehend zu vermeiden und Schichtabplatzungen bzw. Schädigungen zu verhindern.

Rahmenmaterial und auch Abstützelemente können aus Graphit oder Quarzglas, Glaskeramik, andere Keramiken oder hochschmelzenden Gläsern ausgebildet sein (z. B. Graphitkugeln). Auch bei der Auswahl des Materials für die Punktstützen ist auf folgende Materialeigenschaften zu achten: inertes Material, Korrosionsbeständigkeit, mechanische Stabilität, thermische Leitfähigkeit und thermischer Ausdehnungskoeffizient. Der Einsatz von z. B. Graphit-Kugeln in Kombination mit einem Graphit-Rahmenelement ist beispielsweise denkbar.

Selbstständiger Schutz wird beansprucht für eine Anordnung, insbesondere Mehrschichtkörperanordnung, umfassend
- mindestens zwei Gegenständen, insbesondere mindestens zwei Mehrschichtkörper, mit jeweils mindestens einer zu prozessierenden Oberfläche,
- mindestens eine Vorrichtung zum Positionieren der mindestens zwei Gegenstände, so wie sie oben beschrieben ist.

Selbstständiger Schutz wird auch beansprucht für eine Anordnung, insbesondere Mehrschichtkörperanordnung, umfassend mindestens zwei Gegenstände, insbesondere mindestens zwei Mehrschichtkörper, mit jeweils mindestens einer zu prozessierenden Oberfläche, wobei die mindestens zwei Gegenstände, insbesondere die mindestens zwei Mehrschichtkörper, derart angeordnet sind, dass sich die Gegenstände, insbesondere Mehrschichtkörper, gegenüberliegen, wobei die zu prozessierenden Oberflächen voneinander abgewandt sind. Mit dieser Anordnung kann auf eine explizite Vorrichtung zum Positionieren verzichtet werden, vielmehr liegt das untere Substrat mit seiner zu prozessierenden Oberfläche auf geeigneter Stelle auf, z. B. in der Prozessbox oder auch in der Prozesskammer auf dem jeweiligen Boden. Diese Anordnung ist insbesondere dann geeignet, wenn kein Prozessgas für die Prozessierung zugeführt werden muss.

Die Vorrichtung zum Positionieren ist in die Prozesskammer einführbar und aus dieser wieder entfernbar. Die Mehrschichtkörperanordnung ist zweckmäßigerweise außerhalb der Prozessieranlage aufzubauen und anschließend in die Anlage zu transportieren (mittels einer Transportvorrichtung) oder auch manuell einzubringen, damit sie dort dem gewünschten Prozess (z. B. der Selenisierung der Substrate) unterzogen werden kann. Möglich ist es auch, die Vorrichtung zum Positionieren derart in der Prozesskammer anzuordnen, dass sich in dieser die Mehrschichtkörperanordnung aufbauen lässt. Auch können die Mehrschichtkörper ohne die Vorrichtung angeordnet werden. Nach der Umwandlung der Substrate zu den gewünschten Chalkopyrit-Halbleitern ist die Anordnung im Gesamten aus dem Kammerraum entfernbar oder die Einzelteile sind entnehmbar.

Selbstständiger Schutz wird auch beansprucht für eine Anlage zum Prozessieren, insbesondere zum Selenisieren, von mindestens zwei Gegenständen, insbesondere von mindestens zwei Mehrschichtkörpern, mit jeweils mindestens einer zu prozessierenden Oberfläche, umfassend
- mindestens eine Prozesskammer mit einem Kammerraum (auch ein Tunnel ist möglich),
- eine Vorrichtung zum Positionieren der mindestens zwei Gegenstände, so wie sie oben beschrieben ist.

Vorzugsweise weist die Anlage mindestens eine Energiequelle zum Aufheizen der Mehrschichtkörper auf. Vorzugsweise ist die Energiequelle derart an der Prozesskammer bzw. in der Prozessieranlage angeordnet, dass jede der zu prozessierenden Oberflächen direkt beheizt wird. Hierfür können z. B. zwei Energiequellen vorgesehen sein, eine für den unteren Mehrschichtkörper, eine für den oberen Mehrschichtkörper (das heißt, mindestens jeweils eine Energiequelle ist für jeden der Mehrschichtkörper vorgesehen). Vorzugsweise sind jedoch mehrere Energiequellen für jedes Substrat vorgesehen, die z. B. jeweils matrixförmig angeordnet sind. Die Anordnung ist variierbar.

In dieser Anordnung erfolgt die schnelle Aufheizung der Substrate im Wesentlichen also nur einseitig durch das Heizen der jeweiligen Schichtseite: das obere Substrat wird nur von oben, das untere wird nur von unten geheizt. Eine direkte Aufheizung der Glasrückseiten findet nicht statt. Bei hohen Heizraten ist deshalb darauf zu achten, dass es aufgrund unterschiedlicher thermischer Ausdehnungen von Glasober- und -unterseite nicht zu temporärer Scheibenverbiegung kommt. Nach Erreichung der Maximaltemperatur werden die vertikalen Gradienten und damit die Verbiegung jedoch ohnehin wieder ausgeglichen. Da die Dicke des Glases nur 2 bis 3mm beträgt, ist nicht zu erwarten, dass bei Aufheizraten im Bereich von einigen K/sec so starke vertikale Gradienten im Glas aufgebaut werden können, die die Scheibe zum Brechen bringen würden.

Wichtig für geringe Bruchraten ist zudem die laterale Homogenität des Aufheizens (in der Substratfläche). Auch beim Abkühlen ist es erfahrungsgemäß sehr wichtig, die laterale Homogenität zu optimieren. Bei den in dieser Anordnung erreichbaren Abkühlraten, ist es nicht zu erwarten, dass Spannungen im Glas durch vertikale Gradienten zwischen Schichtseite und Rückseite entstehen können.

Die direkte Aufheizung der Schicht bringt sehr gute Aufheizraten mit sich. Hohe Aufheizraten sind in bestimmten Phasen der CIS-Schichtbildung aus den Metallen und Selen von Vorteil.

Eine bevorzugte Ausgestaltung sieht vor, dass in der Prozesskammer mindestens eine Einrichtung zum Ausbilden eines reduzierten Kammerraums anordenbar ist oder angeordnet ist, vorzugsweise eine Prozessbox oder eine Prozesshaube. Einrichtungen dieser Art reduzieren den eigentlichen Raum, der für die Prozessierung zur Verfügung steht und bilden einen expliziten Prozessraum aus (s. o.).

Vorteilhafterweise weist die Prozessbox mindestens ein Deckelelement und ein Bodenelement auf, zwischen welchen die mindestens zwei Mehrschichtkörper angeordnet bzw. anordenbar sind, wobei die Prozessbox in die Prozesskammer (samt der Mehrschichtkörperanordnung) einführbar und aus dieser wieder entfernbar ist. In diesem Falle kann die Mehrschichtkörperanordnung auf dem Bodenelement aufgelegt werden. Mittels des Deckelelements wird die Prozessbox verschlossen. Damit ist die Mehrschichtkörperanordnung definiert im Prozessraum der Anlage untergebracht.

Die Prozesshaube ist üblicherweise zum stationären Verbleib in der Prozessieranlage ausgebildet ist und wird über die z. B. mit der Transportvorrichtung eingebrachte Mehrschichtkörperanordnung gestülpt. Somit ist auch mit der Prozesshaube ein definierter Prozessraum vorgegeben und der Gasaustausch zwischen Prozessraum und Kammerraum ist daher deutlich reduziert.

Wie bereits oben beschrieben, kann die Prozessbox zumindest teilweise auch durch die Vorrichtung zum Positionieren der Gegenstände ausgebildet werden.

Vorzugsweise weist die Anlage ein Gaszufuhrelement und/oder Gasabfuhrelement zum Zuführen und/oder Abführen des Prozessgases in den und/oder aus dem Kammerraum und/oder Prozessraum auf. Wie bereits oben beschrieben, kann dieses z. B. an dem ersten und/oder zweiten Auflageelement vorgesehen sein, je nach Ausgestaltung der Vorrichtung zum Positionieren.

Verfahrensmäßig wird die oben genannte Aufgabe durch ein Verfahren zum Positionieren von mindestens zwei Gegenständen, insbesondere von mindestens zwei Mehrschichtkörpern mit jeweils mindestens einer zu prozessierenden Oberfläche gelöst, mittels einer Vorrichtung zum Positionieren der mindestens zwei Gegenstände, insbesondere Mehrschichtkörper, die zur Aufnahme der mindestens zwei Gegenstände, insbesondere der Mehrschichtkörper, ausgebildet ist, wobei das Verfahren folgende Schritte umfasst:
- Anordnen der Vorrichtung an einer dafür vorgesehenen Stelle,
- Anordnen der zwei Gegenstände, insbesondere Mehrschichtkörper, an der Vorrichtung derart, dass sich die Gegenstände, insbesondere Mehrschichtkörper, gegenüberliegen, wobei die zu prozessierenden Oberflächen voneinander abgewandt sind,
so dass die mindestens zwei Gegenstände als eine Mehrschichtkörperanordnung in einer Prozessieranlage prozessierbar, insbesondere selenisierbar sind.

Es wird angemerkt, dass das erfindungsgemäße Verfahren auch durch Merkmale der Vorrichtung gemäß der abhängigen Ansprüche vorgesehen werden kann.

Vorzugsweise ist der weitere Schritt vorgesehen: Anordnen der Vorrichtung in einer Prozesskammer oder einem Prozesstunnel der Prozessieranlage mit einem Kammerraum und/oder in einer Einrichtung zum Ausbilden eines reduzierten Kammerraums und/oder auf oder an einem Tragelement zum Transportieren der Mehrschichtkörperanordnung mittels einer Transportvorrichtung in die Prozessieranlage (d. h. in die Prozesskammer oder in den Prozesstunnel) und aus dieser heraus oder an einer sonstigen dafür vorgesehenen Stelle.

In einer vorteilhaften Ausgestaltung des Verfahrens kann der Schritt des Anordnens der Vorrichtung folgendermaßen vorgesehen sein:
- Anordnen in einer Prozessbox mit einem Bodenelement, einem Deckelelement und vorzugsweise mit Seitenwandelementen als die Einrichtung zum Ausbilden eines reduzierten Kammerraums oder
- Anordnen innerhalb bzw. unter einer Prozesshaube, die insbesondere zum stationären Verbleib in der Prozessieranlage ausgebildet ist, als die Einrichtung zum Ausbilden eines reduzierten Kammerraums.

Wie bereits oben beschrieben, lässt sich die Mehrschichtkörperanordnung außerhalb der Prozessieranlage aufbauen, z. B. in der Prozessbox, die beispielsweise mit dem Tragelement tranportiert wird oder unmittelbar auf dem Tragelement. Mittels des Tragelements lässt sich die Anordnung dann in die Prozessieranlage fahren. Möglich ist es auch, die Anordnung ohne Tragelement zu transportieren, z. B. mit einem Rollenantrieb. Auch das manuelle Einführen der Anordnung (sowohl der einzelnen Bauteile, als auch der gesamten, vorab zusammengebauten Anordnung) in die Prozessieranlage ist möglich. Im Übrigen kann auch das untere Auflageelement als Tragelement und/oder Transportelement dienen.

Vorzugsweise umfasst das Verfahren den Schritt des Anordnens der zwei Mehrschichtkörper im Gebrauch an der Vorrichtung sandwichförmig übereinanderliegend, so dass ein unterer Mehrschichtkörper und ein oberer Mehrschichtkörper der Mehrschichtkörperanordnung ausgebildet sind. Die im Gebrauch "horizontal" liegenden Körper können so am gleichmäßigsten und am sichersten prozessiert werden.

Da die beiden zu prozessierenden Oberflächen voneinander abgewandt sind, können die Substrate (mit ihren Rückseiten) zur Prozessierung im einfachsten Falle aufeinander gelegt werden. Das heißt, das Verfahren umfasst vorzugsweise den weiteren Schritt des Anordnens der zwei Mehrschichtkörper im Gebrauch an der Vorrichtung derart, dass die Mehrschichtkörper mit den voneinander abgewandten zu prozessierenden Oberflächen aufeinanderliegend positioniert sind.

Vorzugsweise ist der weitere Schritt des Anordnens eines Beabstandungselements vorgesehen, das von der Vorrichtung zum Positionieren umfasst ist, und zwar derart mindestens teilweise zwischen den zwei Mehrschichtkörpern, dass diese beabstandet voneinander positioniert sind. Auf diese Weise wird ein Aneinander"kleben" der Substrate (z. B. aufgrund Adhäsion) vermieden.

In einer weiteren vorteilhaften Ausführung des Verfahrens sind folgende weitere Schritte vorgesehen:
- Anordnen mindestens eines ersten Auflageelements, das von der Vorrichtung zum Positionieren umfasst ist, d. h., das Teil der Vorrichtung ist,
   auf einem Kammerboden und/oder an Kammerseitenwänden der Pozesskammer und/oder
   auf dem Bodenelement und/oder an den Seitenwandelementen der Prozessbox und/oder
   auf oder an dem Tragelement zum Transportieren der Mehrschichtkörperanordnung mittels der Transportvorrichtung in die Prozessieranlage und aus dieser heraus, oder an einer sonstigen dafür vorgesehenen bzw. geeigneten Stelle,
- Anordnen, insbesondere Auflegen des unteren Mehrschichtkörpers vorzugsweise an dessen Kantenbereichen mindestens teilweise an dem oder auf dem ersten Auflageelement.

Ferner können folgende weiteren Schritte vorgesehen sein:
- Anordnen mindestens eines zweiten Auflageelements, das von der Vorrichtung zum Positionieren umfasst ist,
   auf dem Kammerboden und/oder an den Kammerseitenwänden der Pozesskammer und/oder
   auf dem Bodenelement und/oder an den Seitenwandelementen der Prozessbox und/oder
   auf oder an dem ersten Auflageelement und/oder
   auf oder an dem Tragelement zum Transportieren der Mehrschichtkörperanordnung mittels der Transportvorrichtung in die Prozessieranlage und aus dieser heraus, (z. B. Carrier),
   oder an einer sonstigen dafür vorgesehenen Stelle,
- Anordnen, insbesondere Auflegen des oberen Mehrschichtkörpers vorzugsweise an dessen Kantenbereichen mindestens teilweise an dem oder auf dem zweiten Auflageelement.

Ferner ist es vorgesehen, die positionierten Mehrschichtkörper in die Prozessieranlage einzubringen, zu prozessieren und wieder aus der Anlage zu entfernen. Dies ist z. B. mittels der bereits beschriebenen Transportvorrichtung möglich oder auch manuell.

Bei Beladung wird z. B. das untere Substrat an geeigneter Stelle aufgelegt, z. B. auf das untere bzw. erste Auflageelement am Bodenelement einer Prozessbox (oder auch ohne unteres Auflageelement). Dann wird das obere Substrat auf das untere gelegt oder mittels des zweiten Auflageelements positioniert. Schließlich wird das Deckelelement aufgesetzt und die gesamte Box wird in die Prozessanlage gefahren. Im Falle einer Haube wird ggf. der Carrier in die Prozesskammer gefahren und die Haube (mit Deckel und Rahmen) wird auf den Carrier mit der Mehrschichtkörperanordnung gesetzt. Auch kann die Anordnung manuell, also z. B. per Hand in die Prozessieranlage eingebracht werden oder wird in dieser zusammengebaut.

Selbstständiger Schutz wird auch beansprucht für ein Verfahren zum Positionieren von mindestens zwei Gegenständen, insbesondere von mindestens zwei Mehrschichtkörpern mit jeweils mindestens einer zu prozessierenden Oberfläche, wobei das Verfahren folgenden Schritt umfasst:
Anordnen der zwei Gegenstände, insbesondere der zwei Mehrschichtkörper derart,
dass sich die Gegenstände, insbesondere Mehrschichtkörper, gegenüberliegen, wobei die zu prozessierenden Oberflächen voneinander abgewandt sind,
so dass die mindestens zwei Gegenstände als eine Mehrschichtkörperanordnung in einer Prozessieranlage prozessierbar, insbesondere selenisierbar sind.

Konkret heißt dies z. B. Anordnen des unteren Mehrschichtkörpers in der Prozesskammer, in der Prozessbox, auf einem Carrier oder an einer sonstigen geeigneten Stelle und Auflegen des oberen Mehrschichtkörpers auf den unteren, so dass die zu prozessierenden Oberflächen voneinander abgewandt sind. Von einem Prozessraum kann auch gesprochen werden, wenn zumindest eine der zu prozessierenden Oberflächen unmittelbar auf einer entsprechenden geeigneten Stelle (z. B. Kammerboden) aufliegt.

Mit den soeben beschriebenen Verfahrensschritten zum Zusammenbau der Mehrschichtkörperanordnung können die Mehrschichtkörper bzw. Substrate präzise gelagert werden, so dass deren Prozessierung in einer entsprechenden Anlage mit hohem Durchsatz und auf effiziente Weise durchgeführt werden kann.

Im Übrigen und für weitere Details wird auch bezüglich des Verfahrens auf die Ausführungen zu der entsprechenden Vorrichtung zum Positionieren der Gegenstände verwiesen.

Weitere Ausführungsformen der Erfindung ergeben sich aus den Unteransprüchen.

Nachfolgend wird die Erfindung anhand von Ausführungsbeispielen beschrieben, die anhand der Abbildungen näher erläutert werden. Hierbei zeigen:
- Fig. 1 eine Ausführungsform der erfindungsgemäßen Vorrichtung zum Positionieren bzw. Anordnung in einer Einrichtung zum Ausbilden eines reduzierten Kammerraums;
- Fig. 2 eine weitere Ausführungsform der erfindungsgemäßen Vorrichtung bzw. Anordnung in einer Einrichtung zum Ausbilden eines reduzierten Kammerraums;
- Fig. 3 eine weitere Ausführungsform der erfindungsgemäßen Vorrichtung bzw. Anordnung in einer Einrichtung zum Ausbilden eines reduzierten Kammerraums;
- Fig. 4 eine weitere Ausführungsform der erfindungsgemäßen Vorrichtung bzw. Anordnung in einer Einrichtung zum Ausbilden eines reduzierten Kammerraums;
- Fig. 5 eine weitere Ausführungsform der erfindungsgemäßen Vorrichtung bzw. Anordnung in einer Einrichtung zum Ausbilden eines reduzierten Kammerraums;
- Fig. 6 eine weitere Ausführungsform der erfindungsgemäßen Vorrichtung bzw. Anordnung in einer Einrichtung zum Ausbilden eines reduzierten Kammerraums;
- Fig. 7 eine weitere Ausführungsform der erfindungsgemäßen Vorrichtung bzw. Anordnung in einer Einrichtung zum Ausbilden eines reduzierten Kammerraums;
- Fig. 8 eine Anlage zum Prozessieren in einer Schnittdarstellung.

In der nachfolgenden Beschreibung werden für gleiche und gleich wirkende Teile dieselben Bezugsziffern verwendet.

Es wird angemerkt, dass die in den Zeichnungen dargestellten Ausführungsformen Schnitte durch die entsprechenden Anordnungen zeigen, dass aber zugunsten einer übersichtlicheren Darstellung auf Schnittschraffuren verzichtet wurde.

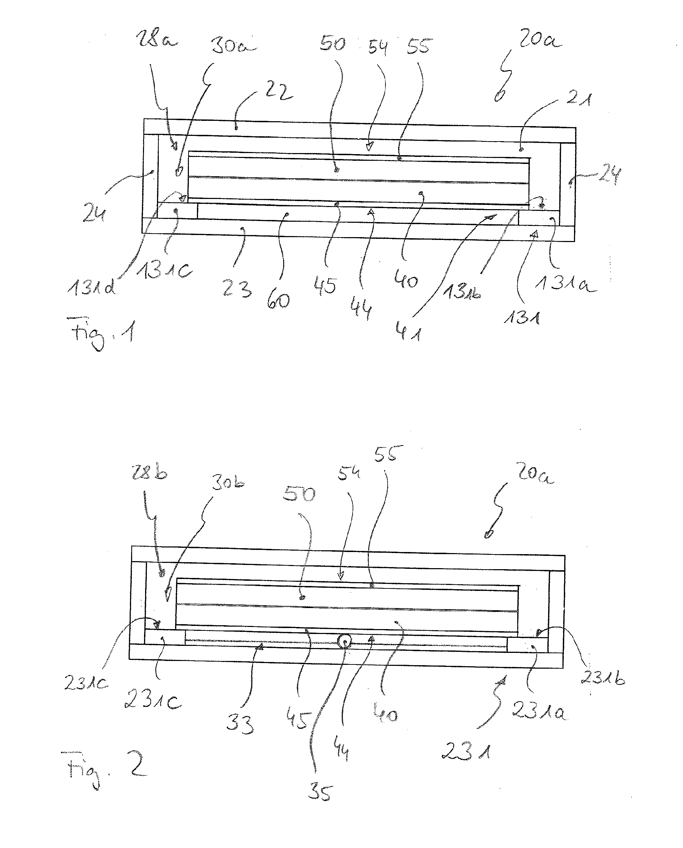

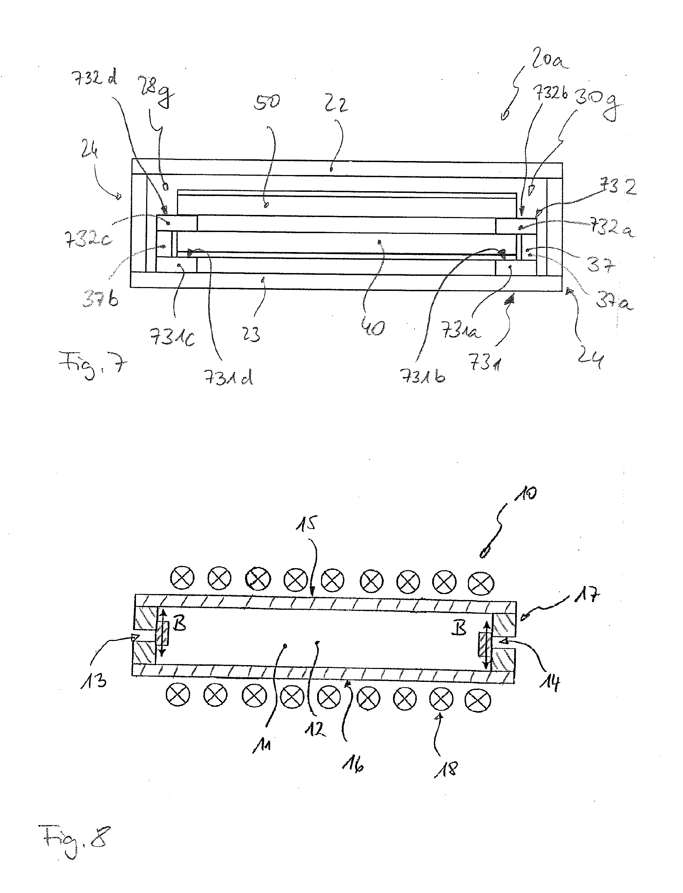

In Fig. 1 ist eine Anordnung zweier Gegenstände gezeigt, wie sie mit einer erfindungsgemäßen Vorrichtung herstellbar ist. Die Gegenstände sind als Mehrschichtkörper, hier als Substrate 40, 50 ausgebildet, die zum Prozessieren, insbesondere zum Selenisieren, vorgesehen sind. Die Substrate weisen an einer Oberfläche 44, 54 eine Beschichtung (Precursor) 45, 55 auf (zu prozessierende Oberflächen). Die Beschichtung (Schichtpaket bestehend z. B. aus Kupfer, Indium und Gallium sowie einer abschließenden Bedeckung aus elementarem Selen, Precursor) soll in einer Prozesskammer einer Prozessieranlage (s. Fig. 8) mit relativ hohen Aufheizraten von bis zu einigen K/s auf höhere Temperaturen gebracht werden, so dass die zuvor aufgetragenen Einzelkomponenten zur Halbleiterverbindung reagieren (schnelle thermische Prozessierung, Rapid Thermal Processing, RTP, von Schichtstapel-Vorläuferschichten, SEL-Precursor, Stacked Elemental Layer). So lassen sich Dünnschichthalbleiter herstellen, beispielsweise Dünnschichtsolarzellen bzw. -module. Solarstromanlagen werden z. B. mit Solarmodulen auf der Basis von Chalkopyrit-Halbleitern (z. B. CuIn-Se₂, abgekürzt "CIS" oder Cu(In,Ga)(S,Se)₂, abgekürzt "CIGSSE") betrieben.

Fig. 8 zeigt eine Prozessieranlage im Schnitt, wie sie zur Prozessierung der Mehrschichtkörper vorgesehen ist. Die Anlage 10 ist ausgelegt, großflächige Substrate zu prozessieren. Zu erkennen ist, dass die Anlage eine Prozesskammer 11 mit einem Kammerdeckel 15, einem Kammerboden 16, Kammerwänden 17 (und damit mit einem Kammerraum 12), eine Eingangstür 13 und eine der Eingangstür gegenüberliegende Ausgangstür 14 aufweist. Die Prozesskammer 11 oder Behandlungskammer weist hier z. B. einen Tunnel auf bzw. bildet einen Tunnel aus, der beispielsweise mit den Türen (Schleusen) abdichtbar ist. Die Pfeile B deuten die Bewegungsrichtung der Eingangstür bzw. der Ausgangstür an.

Zum Transport der mindestens beiden Mehrschichtkörper bzw. der Mehrschichtkörperanordnung (hier nicht gezeigt) kann z. B. eine Transportvorrichtung (nicht gezeigt) vorgesehen sein, die die Substrate durch die Türen bzw. Schleusen 13, 14 durch die Prozesskammer 11 transportieren kann. Ober- und unterhalb der Prozesskammer 11 sind mehrere punktförmige Quellen 18 für elektromagnetische Strahlung z. B. matrixartig angeordnet. Auch eine andere Art von Quellen und/oder einen andere Anordnung dieser Quellen ist möglich. Zum Durchlass der Strahlung sind mindestens der Kammerdeckel 15 und der Kammerboden 16 der Prozesskammer 11 zumindest bereichsweise zumindest teiltransparent ausgebildet, um eine homogene Energieeinwirkung auf die Substrate zu ermöglichen.

Die Energiequellen können auch innerhalb der Kammer 11 angeordnet sein, dann kann die Wandung der Prozesskammer auch nicht-transparent ausgebildet sein. Auch ist es möglich, die Energiequellen in den entsprechenden Wänden oder Wandabschnitten der Kammer anzuordnen und/oder die Wände derart auszubilden, dass diese unter Einwirkung von Energiequellen als Sekundärstrahler dienen.

Die Prozessierung kann mit eingebrachtem Prozessgas erfolgen. Hierfür eignen sich z. B. H₂, N₂, Ar, H₂S, H₂Se, S-Gas, Se-Gas und/oder andere Gase. Grundsätzlich ist auch an eine Prozessierung ohne jeglichen Gasaustausch (z. B. zwischen Prozesskammer und Prozessbox bzw. zwischen einer Gasquelle und der Prozesskammer bzw. Prozessbox oder -haube) zu denken.

Fluid- insbesondere Gasaustausch zwischen den Ebenen der Prozessieranlage ist auf unterschiedliche Weise möglich. So kann z. B. der Austausch von Gas zwischen einer (z. B. externen) Gasquelle, der Prozesskammer (oder dem Prozesstunnel) und ggf. der Prozessbox oder ―haube erfolgen. Auch kann der Gasaustausch zwischen externer Gasquelle und einer ggf. vorhandenen Prozessbox oder ―haube unter Umgehung der Prozesskammer erfolgen, d. h., die Prozessbox steht mit der Gasquelle unmittelbar in Verbindung.

Zurück zur erfindungsgemäßen Vorrichtung bzw. Anordnung. Die Mehrschichtkörper 40, 50 sind derart angeordnet, dass die zu prozessierenden Oberflächen 44, 54 voneinander abgewandt sind (Dual-Substrate Back-to-Back RTP). Die Substrate 40, 50 liegen dabei im Gebrauch horizontal und sind sandwichförmig übereinander angeordnet. Insofern kann von einem unteren Mehrschichtkörper 40 bzw. einem unteren Substrat und einem oberen Mehrschichtkörper 50 bzw. einem oberen Substrat gesprochen werden. Deren Lagerungsmöglichkeiten werden nachfolgend detailliert beschrieben.

In der oben beschriebenen Anlage 10 ist es oftmals erwünscht, den Kammerraum 12 der Prozesskammer 11 zu verringern, um die Prozessgaszufuhr bzw. auch -abfuhr und auch die Prozessgasmenge besser kontrollieren zu können. In einem definierten Raum ist auch die Prozessierung, also z. B. die Umwandlung der beschichteten Substratoberflächen besser kalkulier- und nachvollziehbar. Insofern ist der definierte Prozessraum zweckmäßig.

Hierfür ist z. B. in Kammerräumen einer Prozesskammer eine Einrichtung zur Ausbildung eines reduzierten Kammerraums (und damit zur Ausbildung des bereits beschriebenen Prozessraums) anordenbar oder angeordnet. Solche Einrichtungen sind beispielsweise als sogenannte Prozessboxen innerhalb der Prozesskammer vorgesehen, in welche die zu prozessierenden Substrate aufgenommen werden. Auch sind Prozesshauben bekannt, die über die zu prozessierenden Substrate gestülpt (auf die Substrate abgesenkt) werden und auf z. B. dem unteren Substrat, auf dem Kammerboden oder einer expliziten Auflage aufliegen.

Die aufeinander gestapelten Substrate 40, 50 sind hier in einer Prozessbox 20a untergebracht, die mittels der Transportvorrichtung in die oben beschriebene Prozessieranlage eingebracht und nach der Prozessierung wieder aus der Anlage herausgenommen werden kann (auch ein manuelles Einbringen und Herausnehmen ist möglich). Die Prozessbox weist ein Deckelelement 22, ein Bodenelement 23 und Seitenwandelemente 24 auf. Die vordere Seitenwand ist nicht sichtbar.

Die beiden Substrate 40, 50 werden aufgrund ihrer Anordnung gleichzeitig prozessiert, also z. B. selenisiert, so dass sich der Durchsatz durch die Anlage (z. B. wie mit Fig. 8 gezeigt) deutlich erhöht. Der definierte Raum in der Prozessbox 20a, der sogenannte Prozessraum 21, kann gezielt mit einer bestimmten Menge eines Prozessgases für die Durchführung der Prozessierung befüllt werden. Das heißt, in dem Prozessraum 21 erfolgt letztendlich im Wesentlichen die Prozessierung.

Im Prinzip kann von einem "oberen" und einem "unteren" Prozessraum gesprochen werden, nämlich von einem Raum zwischen Deckelelement und oberem Substrat und Bodenelement und unterem Substrat.

Die Substrate 40, 50 sind in dieser Ausführungsform unmittelbar aufeinander gelegt und auf einer Vorrichtung 30a zum Positionieren der Substrate 40, 50 derart gelagert, dass die zu prozessierenden Oberflächen voneinander abgewandt sind. Die Precursor-Schicht 55 des oberen Substrats 50 ist nach "oben" gerichtet, die Precursor-Schicht 45 des unteren Substrats 40 nach "unten". Diese Anordnung ist auf einem ersten Auflageelement 131 der Vorrichtung 30a positioniert bzw. abgestützt. Das Auflageelement 131 umfasst zwei Rahmenleistenelemente 131 a und 131c mit jeweils einer Auflagefläche bzw. einem Auflagebereich 131b bzw. 131d, wobei die Leisten auf dem Bodenelement 23 der Prozessbox 20a angeordnet sind (fest mit dem Bodenelement verbunden oder einfach aufgelegt). Mit Kantenbereichen 41 ist der untere Mehrschichtkörper 40 auf den Leistenelementen gelagert und trägt selbst wiederum den oberen Mehrschichtkörper 50. Somit ist eine Mehrschichtkörperanordnung 28a ausgebildet.

Damit die zu prozessierenden Oberflächen 44, 45 mit dem Prozessgas in ausreichenden Kontakt kommen können, muss das Auflageelement 131 mindestens teilweise offen sein. So liegt hier z. B. das untere Substrat nur an dessen Längsseiten auf den Leistenelementen 131 a, 131c auf, während über die Querseiten die Gaszirkulation stattfinden kann. Das heißt, die Anordnung 28a weist jeweils einen Öffnungsbereich an den Querseiten der Substrate bzw. der Anordnung auf. Hier ist der Öffnungsbereich 60 sichtbar. Möglich ist es natürlich auch, den oder die Öffnungsbereich(e) an den Längsseiten vorzusehen. Damit ein Gasstrom über die zu prozessierenden Oberflächen ziehen kann, liegt dem Öffnungsbereich 60 vorzugsweise ein zweiter Öffnungsbereich gegenüber (hier vor allem für das untere Substrat).

Die Mehrschichtkörperanordnung 28a könnte ebenfalls auf einem Carrier aufgebaut und mittels einer Transportvorrichtung in die Prozesskammer oder in einen Prozesstunnel der Prozessieranlage eingebracht werden (in der sich z. B. eine Prozesshaube befindet, die auf die Mehrschichtkörperanordnung absenkbar ist). Auch ohne eine explizite Einrichtung zur Ausbildung eines reduzierten Kammerraums ließe sich die Prozessierung durchführen.

Fig. 2 zeigt eine ähnliche Ausführungsform, wie sie mit Fig. 1 gezeigt ist, allerdings weist ein Auflageelement 231 einer Vorrichtung 30b zum Positionieren ein Querverbindungselement 33 zum Verbinden von sich gegenüberliegenden Rahmenleistenelemente 231a, 231c auf, so dass der oder die Mehrschichtkörper 40, 50 zur Vermeidung einer Durchbiegung zusätzlich abstützbar ist bzw. sind. Die Mehrschichtkörperanordnung 28b ist somit stabiler ausgebildet.

Um nun aber die zu prozessierenden Oberflächen 44, 54 nicht zu sehr abzudecken, weist das Querverbindungselement 33 mindestens ein (erstes) Abstützelement 35 auf, auf das oder an das das Substrat bzw. die Substrate auflegbar oder anlegbar ist bzw. sind. In diesem Falle ist das Abstützelement 35 derart ausgebildet, dass es dieselbe Höhe hat, wie die Leisten 231a, 231c. Nur so ist eine ebene Auflagefläche für die Substrate 40, 50 gewährleistet. Sowohl die Rahmenleisten 231a, 231c, als auch das Querverbindungselement 33 können ein oder auch mehrere Abstützelemente aufweisen. Die Auflagebereiche reduzieren sich dadurch, so dass die Substrate an den zu prozessierenden Oberflächen 44, 54 möglichst frei liegen.

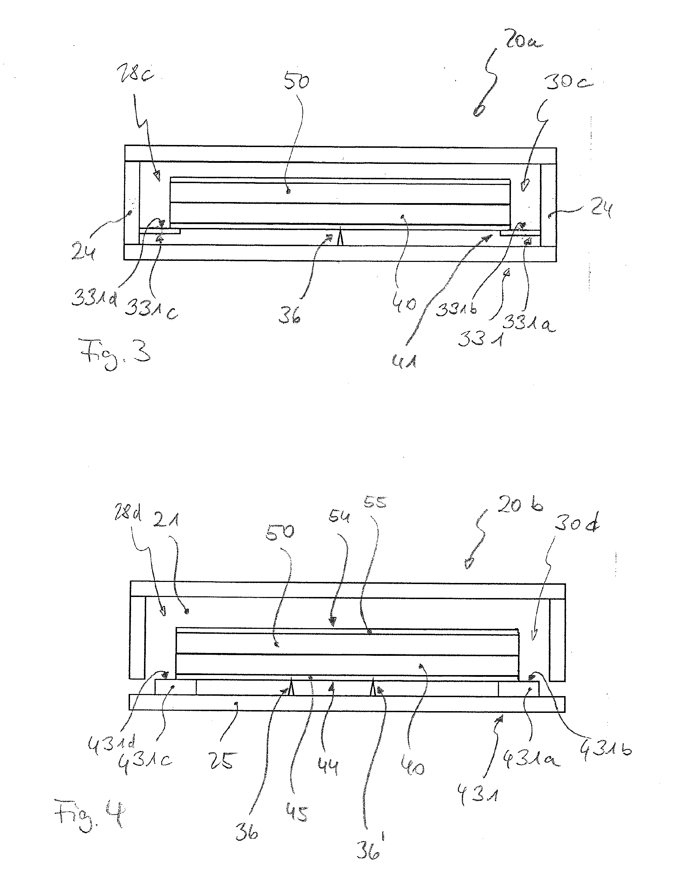

Die Anzahl der Querverbindungselemente und der Abstützelemente ist beliebig und je nach Bedarf variierbar. Auch die Anordnung der Abstützelemente ist variierbar, d. h. die Abstützelemente können an den Auflageelementen und/oder an den Querverbindungselementen angeordnet sein. Das oder die Abstützelement(e) 35 sind vorzugsweise als Punktstützenelemente ausgebildet, also z. B. kugelförmig. Mit den Kugelelementen sind nur kleine Auflagebereiche vorgesehen. Eine noch geringere Abschattung der Strahlung der Strahler 18 wird durch nadelförmige Elemente erreicht (s. z. B. Fig. 3).

Fig. 3 zeigt eine Mehrschichtkörperanordnung 28c mit einer Vorrichtung 30c zum Positionieren der Substrate 40, 50, wobei die Anordnung ebenfalls in einer Prozessbox 20a untergebracht ist.

Die Substrate 40, 50 sind auf einem ersten Auflageelement 331 gelagert bzw. gestützt, wobei das Auflageelement 331 auch in dieser Ausführungsform zwei Rahmenleistenelemente 331a, 331c mit jeweils einer Auflagefläche bzw. einem Auflagebereich 331b, 331d aufweist. Die Leisten 331a, 331c sind hier nicht am Bodenelement sondern an Seitenwandelementen 24 der Prozessbox angebracht. Zusätzlich ist ein (zweites) Abstützelement 36 am Bodenelement angeordnet und stützt die Mehrschichtkörper zusätzlich ab, so dass eine Durchbiegung der Körper im Wesentlichen verhindert werden kann. Mehrere dieser zweiten Abstützelemente wären denkbar.

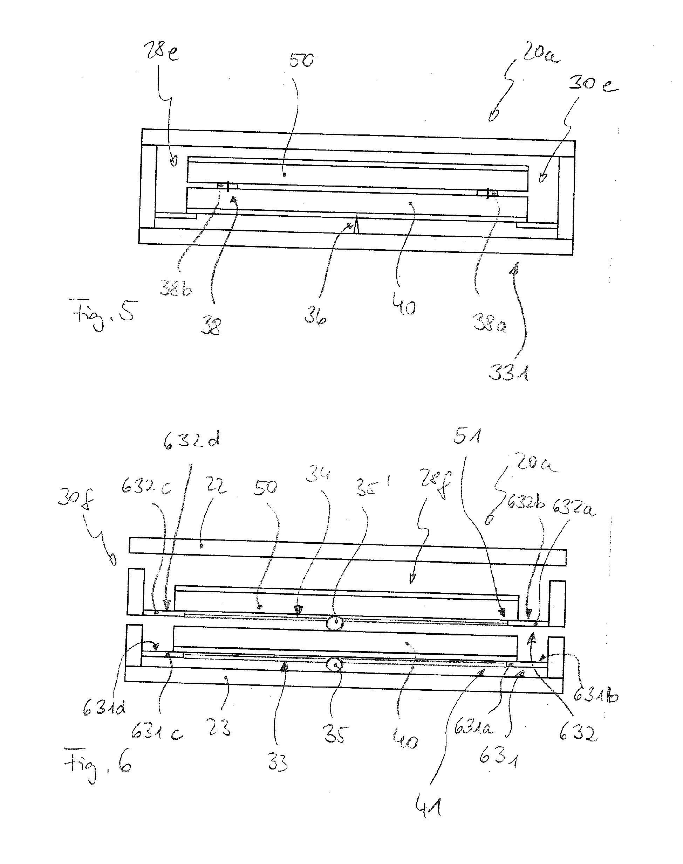

Möglich ist es auch, dass die Rahmenleistenelemente, also das erste Auflageelement der Vorrichtung zur Positionierung, derart ausgebildet sind, dass sie die Seitenwandelemente der Prozessbox ausbilden (gut erkennbar z. B. in Fig. 6).

Fig. 4 zeigt eine Mehrschichtkörperanordnung 28d mit einer Vorrichtung 30d zum Positionieren der Substrate 40, 50, wobei die Anordnung unter einer Prozesshaube 20b positioniert ist.

Die Mehrschichtkörperanordnung 28d ist hier auf einem Carrier 25 angeordnet, der die Mehrschichtkörperanordnung 28d mittels der nicht gezeigten Transportvorrichtung in die Anlage zum Prozessieren einbringt. In der Prozesskammer bzw. im -tunnel befindet sich die Prozesshaube 20b, die dann auf den Carrier mit der Mehrschichtkörperanordnung 28d abgesenkt wird, um so den definierten Prozessraum 21 auszubilden.

Die Vorrichtung 30d umfasst hier wiederum ein ersten Auflageelement 431 mit zwei Rahmenleistenelementen 431a, 431c, wobei die Mehrschichtkörper 40, 50 auf Auflagebereichen 431b, 431d aufliegen (Kantenbereiche 41). Das Auflageelement ist ähnlich wie das mit Fig. 1 gezeigte aufgebaut. Das Substrat 50 liegt auf dem Substrat 40 auf, wobei die zu prozessierenden Oberflächen 44, 54 mit den jeweiligen Beschichtungen 45, 55 voneinander abgewandt sind.

Ferner umfasst die Vorrichtung 30d hier zwei (zweite) Abstützelemente 36, 36', die am Carrier 25 angeordnet sind und die Substrate 40, 50 zusätzlich abstützen. Die nadelförmige Ausgestaltung der Abstützelemente schattet die zu prozessierende Oberfläche kaum ab, so dass sie für die Prozessierung im Wesentlichen frei zugänglich ist.

Fig. 5 zeigt im Wesentlichen die Anordnung gemäß Fig. 3, mit einer Vorrichtung 30e zum Positionieren der Mehrschichtkörper 40, 50, mit der eine Mehrschichtkörperanordnung 28e ausgebildet ist. Das Auflageelement 331 entspricht demjenigen aus Fig. 3. Im Unterschied zu Fig. 3 sind die beiden Substrate hier mit einem Beabstandungselement 38 positioniert bzw. gelagert. Das Beabstandungselement 38 umfasst hier z. B. zwei Leistenelemente 38a, 38b und ist zwischen den beiden Substraten 40, 50 (auf den nicht zu prozessierenden Oberflächen) gelagert, so dass die Substrate voneinander beabstandet angeordnet sind.

Fig. 6 zeigt schließlich eine weitere Ausführungsform der erfindungsgemäßen Vorrichtung 30f zum Positionieren der beiden Substrate 40, 50, die in einer Mehrschichtkörperanordnung 28f angeordnet sind. Zur Lagerung der beiden Substrate 40, 50 in der Prozessbox 20a sind hier ein erstes Auflageelement 631 und ein zweiten Auflageelement 632 vorgesehen. Das erste Auflageelement 631 umfasst wiederum zwei Rahmenleistenelemente 631a, 631c mit jeweils einem Auflagebereich bzw. einer Auflagefläche 631b, 631d. Das zweite Auflageelement 632 umfasst ebenfalls zwei Rahmenleistenelemente 632a, 632c mit jeweils einem Auflagebereich bzw. einer Auflagefläche 632b, 632d. Die Substrate 40, 50 liegen jeweils mit ihren Kantenbereichen 41, 51 auf den jeweiligen Auflageflächen 631b, 631d, 632b, 632d auf.

Die beiden Auflageelemente 631, 632 sind derart ausgebildet, dass sie aufeinander stapelbar sind, so dass die Substrate 40, 50 wiederum sandwichförmig anordenbar bzw. positionierbar sind. Die jeweiligen Rahmenleistenelemente sind hier im Querschnitt L-förmig ausgebildet und bilden so die Seitenwandelemente der Prozessbox 20a aus. Möglich ist es natürlich auch, explizite Seitenwandelemente der Prozessbox 20a vorzusehen und die Auflageelemente an diesen zu befestigen (z. B. wieder entfernbar, so dass die Prozessbox auch für andere Anordnungen der Substrate nutzbar ist).

Mit der Einzellagerung der Substrate wirken auf das untere Substrat 40 weniger Kräfte, so dass auch dessen etwaige Durchbiegung geringer ist.

In dieser Ausgestaltung weisen die Auflageelemente 631, 632 jeweils ein Querverbindungselement 33 und 34 auf, wobei sowohl an dem "oberen" Querverbindungselement 34, als auch an dem "unteren" Querverbindungselement 33 ein Abstützelement 35 bzw. 35' angeordnet ist. Das Abstützelement 35' des zweiten (oberen) Auflageelements 632 liegt auf der Substratrückseite des unteren Substrats auf (und stützt natürlich das obere Substrat). Die Ausführungsform lässt sich auch ohne diese Querverbindungselemente realisieren.

Fig. 7 zeigt eine Mehrschichtkörperanordnung 28g mit einer Vorrichtung 30g zum Positionieren der Substrate 40, 50, wobei die Anordnung wiederum in der Prozessbox 20a positioniert ist.

Die Vorrichtung 30g umfasst ein erstes Auflageelement 731 (mit Rahmenleistenelement 731a, Auflagebereich 731b, Rahmenleistenelement 731c, Auflagebereich 731d), ein zweites Auflageelement 732 (mit Rahmenleistenelement 732a, Auflagebereich 732b, Rahmenleistenelement 732c, Auflagebereich 732d) und ein Zwischenelement 37, ggf. auch mit Leistenelementen 37a, 37b, das zwischen dem ersten Auflageelement 731 und dem zweiten Auflageelement 732 angeordnet ist, so dass die drei Elemente im Querschnitt eine im Wesentlichen C-förmige Anordnung ausbilden. Das erste Auflageelement 731 liegt auf dem Bodenelement 23 der Prozessbox 20a auf. Auflageelement 731, Auflageelement 732 und Zwischenelement 37 können auch einstückig (zumindest die jeweiligen Leistenelemente) ausgebildet sein. Die Prozessbox 20a weist explizite Seitenwandelemente 24 auf.

Auch mit dieser Anordnung ist das untere Substrat 40 entlastet und dessen möglicher Durchbiegung wird entgegengewirkt.

In den gezeigten Ausführungsformen sind die Auflageelemente als Leistenelemente ausgebildet, so dass jeweils an den Querseiten der Anordnungen Öffnungsbereiche 60 für den Gasaustausch zwischen Prozessraum und Kammerraum verbleiben (insbesondere für die Precursor-Schicht des unteren Mehrschichtkörpers). Möglich wäre es auch, geschlossene Rahmenelemente zu verwenden und mindestens ein Gaszufuhr- und -abfuhrelement vorzusehen. Dies kann z. B. als Gasverteilerkamm in dem jeweiligen Rahmenelement realisiert und mit Andockstößel (Anschlusselementen) für Gasanschlussleitungen versehen sein. Wichtig wäre dies insbesondere für den unteren Mehrschichtkörper, da der obere bzw. die obere Precursor-Schicht ohnehin "frei" liegt. Im Übrigen können die Öffnungsbereiche auch an den Längsseiten der Anordnung vorgesehen sein oder die Auflageelemente sind derart ausgebildet, dass sowohl an den Querseiten als auch an den Längsseiten Öffnungsbereiche vorgesehen sind. Bei quadratisch ausgebildeten Substraten wird nicht zwischen Längs- und Querseiten unterschieden.

Fig. 8 zeigt schließlich die bereits oben beschriebene Anlage 10, in die die Anordnungen 28a, 28b, 28c, 28d, 28e, 28f und/oder 28g mit den Vorrichtungen 30a, 30b, 30c, 30d, 30e, 30f und/oder 30g zum Positionieren (hier nicht eingezeichnet) zum Prozessieren mit oder ohne explizite Einrichtung zum Ausbilden eines reduzierten Kammerraums eingebracht werden können.

Der Transport der Anordnung bzw. der Vorrichtung (mit oder ohne Einrichtung zum Ausbilden eines reduzierten Kammerraums) in die Anlage und aus dieser heraus erfolgt beispielsweise über die Transportvorrichtung (nicht gezeigt), die mit oder ohne Träger (z. B. Carrier) für die Substrate arbeitet oder aber erfolgt manuell. Auch kann die Anordnung unmittelbar in der Prozessieranlage zusammengebaut werden.

Mit der vorgestellten Vorrichtung zum Positionieren von Gegenständen, mit einer damit ausgebildeten Mehrschichtkörperanordnung, mit einer Mehrschichtkörperanordnung, die ohne Vorrichtung zum Positionieren zusammengebaut ist, einer Anlage zum Prozessieren der Mehrschichtkörperanordnung und mit den entsprechenden Verfahren zum Ausbilden der Mehrschichtkörperanordnung lassen sich Mehrschichtkörper, z. B. Substrate, auf einfache Weise mit hohem Durchsatz prozessieren (beispielsweise zur Herstellung von Chalkopyrit-Halbleitern).

### Bezugszeichenliste

- 10: Anlage zum Prozessieren
- 11: Prozesskammer, -tunnel
- 12: Kammerraum
- 13: Eingangstür
- 14: Ausgangstür
- 15: Kammerdeckel
- 16: Kammerboden
- 17: Kammer(seiten)wand bzw. -wände
- 18: Quelle(n) für elektromagnetische Strahlung
- 20a: Einrichtung zur Ausbildung eines reduzierten Kammerraums, Prozessbox
- 20b: Einrichtung zur Ausbildung eines reduzierten Kammerraums, Prozesshaube
- 21: Prozessraum
- 22: Deckelelement
- 23: Bodenelement
- 24: Seitenwandelement(e)
- 25: Tragelement, Carrier
- 28a: Anordnung, Mehrschichtkörperanordnung
- 28b: Anordnung, Mehrschichtkörperanordnung
- 28c: Anordnung, Mehrschichtkörperanordnung
- 28d: Anordnung, Mehrschichtkörperanordnung
- 28e: Anordnung, Mehrschichtkörperanordnung
- 28f: Anordnung, Mehrschichtkörperanordnung
- 28g: Anordnung, Mehrschichtkörperanordnung
- 30a: Vorrichtung zum Positionieren
- 30b: Vorrichtung zum Positionieren
- 30c: Vorrichtung zum Positionieren
- 30d: Vorrichtung zum Positionieren
- 30e: Vorrichtung zum Positionieren
- 30f: Vorrichtung zum Positionieren
- 30g: Vorrichtung zum Positionieren
- 131: Erstes Auflageelement
- 131a: Rahmenleistenelement
- 131b: Auflagebereich
- 131c: Rahmenleistenelement
- 131d: Auflagebereich
- 231: Erstes Auflageelement
- 231a: Rahmenleistenelement
- 231b: Auflagebereich
- 231c: Rahmenleistenelement
- 231d: Auflagebereich
- 331: Erstes Auflageelement
- 331a: Rahmenleistenelement
- 331b: Auflagebereich
- 331c: Rahmenleistenelement
- 331d: Auflagebereich
- 431: Erstes Auflageelement
- 431a: Rahmenleistenelement
- 431b: Auflagebereich
- 431c: Rahmenleistenelement
- 431d: Auflagebereich
- 631: Erstes Auflageelement
- 631a: Rahmenleistenelement
- 631b: Auflagebereich
- 631c: Rahmenleistenelement
- 631d: Auflagebereich
- 731: Erstes Auflageelement
- 731a: Rahmenleistenelement
- 731b: Auflagebereich
- 731c: Rahmenleistenelement
- 731d: Auflagebereich
- 632: Zweites Auflageelement
- 632a: Rahmenleistenelement
- 632b: Auflagebereich
- 632c: Rahmenleistenelement
- 632d: Auflagebereich
- 732: Zweites Auflageelement
- 732a: Rahmenleistenelement
- 732b: Auflagebereich
- 732c: Rahmenleistenelement
- 732d: Auflagebereich
- 33: Querverbindungselement
- 34: Querverbindungselement
- 35: Abstützelement
- 35': Abstützelement
- 36: Abstützelement
- 36': Abstützelement
- 37: Zwischenelement
- 37a: Leistenelement des Zwischenelements
- 37b: Leistenelement des Zwischenelements
- 38: Beabstandungselement
- 38a: Leistenelement des Beabstandungselements
- 38b: Leistenelement des Beabstandungselements
- 40: Unterer Mehrschichtkörper, Substrat
- 41: Kantenbereich(e)
- 44: Zu prozessierende Oberfläche
- 45: (Precursor-) Beschichtung
- 50: Oberer Mehrschichtkörper, Substrat
- 51: Kantenbereich(e)
- 54: Zu prozessierende Oberfläche
- 55: (Precursor-) Beschichtung
- 60: Öffnungsbereich Anordnung
- B: Bewegungsrichtung Eingangstür, Ausgangstür

## Patentansprüche

1. Vorrichtung (30a, 30b, 30c, 30d, 30e, 30f, 30g) zum Positionieren von mindestens zwei Gegenständen, insbesondere von mindestens zwei Mehrschichtkörpern (40, 50) mit jeweils mindestens einer zu prozessierenden Oberfläche (44, 54),
wobei die Vorrichtung (30a bis 30g) zur Aufnahme der mindestens zwei Gegenstände, insbesondere Mehrschichtkörper (40, 50), derart ausgebildet ist, dass sich die Gegenstände, insbesondere Mehrschichtkörper (40, 50), gegenüberliegen, wobei die zu prozessierenden Oberflächen (44, 54) voneinander abgewandt sind,
so dass die mindestens zwei Gegenstände als eine Mehrschichtkörperanordnung (28a, 28b, 28c, 28d, 28e, 28f, 28g) in einer Prozessieranlage (10) prozessierbar, insbesondere selenisierbar sind.

2. Vorrichtung nach Anspruch 1,
**dadurch gekennzeichnet, dass**
die Vorrichtung (30a bis 30g) derart ausgebildet ist, dass sie in einer Prozesskammer oder einem Prozesstunnel (11) der Prozessieranlage (10) mit einem Kammerraum (12) und/oder
in einer Einrichtung (20a, 20b) zum Ausbilden eines reduzierten Kammerraums,
vorzugsweise
- in einer Prozessbox (20a) mit einem Bodenelement (23), einem Deckelelement (22) und vorzugsweise mit Seitenwandelementen (24) oder
- innerhalb einer Prozesshaube (20b), die insbesondere zum stationären
Verbleib in der Prozessieranlage (10) ausgebildet ist,
und/oder
auf oder an einem Tragelement (25) zum Transportieren der Mehrschichtkörperanordnung (28a bis 28g) mittels einer Transportvorrichtung in die Prozessieranlage (10) und aus dieser heraus,
anordenbar oder angeordnet ist.

3. Vorrichtung nach Anspruch 1 oder 2, insbesondere nach Anspruch 2,
**dadurch gekennzeichnet, dass**
mindestens ein Teil der Vorrichtung (30a bis 30g) mindestens einen Teil der Prozessbox (20a), insbesondere mindestens teilweise die Seitenwandelemente der Prozessbox (20a) ausbildet.

4. Vorrichtung nach einem der vorhergehenden Ansprüche,
**dadurch gekennzeichnet, dass**
die Vorrichtung (30a bis 30g) derart ausgebildet ist, dass die Mehrschichtkörper (40, 50) im Gebrauch sandwichförmig übereinanderliegend angeordnet sind und so einen unteren Mehrschichtkörper (40) und einen oberen Mehrschichtkörper (50) der Mehrschichtkörperanordnung (28a bis 28g) ausbilden.

5. Vorrichtung nach einem der vorhergehenden Ansprüche,
**dadurch gekennzeichnet, dass**
die Vorrichtung (30a bis 30g) derart ausgebildet ist, dass die Mehrschichtkörper (40, 50) mit den voneinander abgewandten zu prozessierenden Oberflächen (44, 54) aufeinanderliegend positionierbar sind.

6. Vorrichtung nach einem der vorhergehenden Ansprüche,
**dadurch gekennzeichnet, dass**
die Vorrichtung (30a bis 30g) mindestens ein Beabstandungselement (38) aufweist, wobei das Beabstandungselement (38) derart mindestens teilweise zwischen den zwei Mehrschichtkörpern (40, 50) anordenbar ist, dass diese beabstandet voneinander positionierbar sind.

7. Vorrichtung nach einem der vorhergehenden Ansprüche,
**dadurch gekennzeichnet, dass**
die Vorrichtung (30a bis 30g) mindestens ein erstes Auflageelement (131, 231, 331, 431, 631, 731) aufweist,
das auf einem Kammerboden (16) und/oder an Kammerseitenwänden (17) der Pozesskammer (11) und/oder
auf dem Bodenelement (23) und/oder an den Seitenwandelementen (24) der Prozessbox (20a) und/oder
auf oder an dem Tragelement (25) zum Transportieren der Mehrschichtkörperanordnung (28a bis 28g) mittels der Transportvorrichtung in die Prozessieranlage (10) und aus dieser heraus,
anordenbar oder angeordnet ist,
wobei das erste Auflageelement (131, 231, 331, 431, 631, 731) derart ausgebildet ist, dass der untere Mehrschichtkörper (40) vorzugsweise an dessen Kantenbereichen (41) mindestens teilweise an dem ersten Auflageelement (131, 231, 331, 431, 631, 731) anordenbar, insbesondere auf das Auflageelement (131, 231, 331, 431, 631, 731) auflegbar ist.

8. Vorrichtung nach einem der vorhergehenden Ansprüche,
**dadurch gekennzeichnet, dass**
die Vorrichtung (30a bis 30g) mindestens ein zweites Auflageelement (632, 732) aufweist,
das auf dem Kammerboden (16) und/oder an den Kammerseitenwänden (17) der Pozesskammer (11) und/oder
auf dem Bodenelement (23) und/oder an den Seitenwandelementen (24) der Prozessbox (20a) und/oder
auf oder an dem ersten Auflageelement (131, 231, 331, 431, 631, 731) und/oder
auf oder an dem Tragelement (25) zum Transportieren der Mehrschichtkörperanordnung (28a bis 28g) mittels der Transportvorrichtung in die Prozessieranlage (10) und aus dieser heraus,
anordenbar oder angeordnet ist,
wobei das zweite Auflageelement (632, 732) derart ausgebildet ist, dass der obere Mehrschichtkörper (50) vorzugsweise an dessen Kantenbereichen (51) mindestens teilweise an dem zweiten Auflageelement (632, 732) anordenbar, insbesondere auf das Auflageelement (632, 732) auflegbar ist.

9. Vorrichtung nach einem der vorhergehenden Ansprüche, insbesondere nach Anspruch 7 oder 8,
**dadurch gekennzeichnet, dass**
zum einen das erste Auflageelement (131, 231, 331, 431, 631, 731) und/oder das zweite Auflageelement (632, 732) jeweils als ein Rahmenelement, vorzugsweise als ein die Konturen der Mehrschichtkörper (40, 50) nachbildend rechteckförmig oder quadratisch ausgebildetes Rahmenelement vorgesehen sind, so dass die Mehrschichtkörper (40, 50) vorzugsweise an deren Kantenbereichen (41, 51) mindestens teilweise an dem jeweiligen Rahmenelement anordenbar, insbesondere auf das Rahmenelement auflegbar sind,
und/oder zum anderen das erste Auflageelement (131, 231, 331, 431, 631, 731) und/oder das zweite Auflageelement (632, 732) jeweils als zwei, in einer Erstreckungsebene der Mehrschichtkörper (40, 50) sich im Gebrauch gegenüberliegende Rahmenleistenelemente (131a, 131c, 231a, 231c, 331a, 331c, 431a, 431c, 631a, 631c, 731a, 731c, 632a, 632c, 732a, 732c) ausgebildet sind, so dass die Mehrschichtkörper (40, 50) vorzugsweise an deren Kantenbereichen (41, 51), vorzugsweise an deren Längsseiten, mindestens teilweise an den Rahmenleistenelementen anordenbar, insbesondere auf die Rahmenleistenelemente auflegbar sind.

10. Vorrichtung nach einem der vorhergehenden Ansprüche, insbesondere nach einem der Ansprüche 7 bis 9,
**dadurch gekennzeichnet, dass**
die Vorrichtung (30a bis 30g) ein Zwischenelement (37) umfasst, das zwischen dem ersten Auflageelement (131, 231, 331, 431, 631, 731) und dem zweiten Auflageelement (632, 732) anordenbar ist, so dass das zweite Auflageelement (632, 732) auf dem ersten Auflageelement (131, 231, 331, 431, 631, 731) lagerbar ist.

11. Vorrichtung nach einem der vorhergehenden Ansprüche, insbesondere nach einem der Ansprüche 7 bis 10,
**dadurch gekennzeichnet, dass**
das erste Auflageelement (131, 231, 331, 431, 631, 731) und/oder das zweite Auflageelement (632, 732) jeweils mindestens ein Querverbindungselement (33, 34) zum Verbinden von, in der Erstreckungsebene der Mehrschichtkörper (40, 50) sich gegenüberliegenden Bereichen des jeweiligen Rahmenelements oder von sich im Gebrauch gegenüberliegenden Rahmenleistenelementen (131a, 131c, 231a, 231c, 331a, 331c, 431a, 431c, 631a, 631c, 731a, 731c, 632a, 632c, 732a, 732c) aufweisen, so dass der oder die Mehrschichtkörper (40, 50) zur Vermeidung einer Durchbiegung zusätzlich abstützbar ist oder sind.

12. Vorrichtung nach einem der vorhergehenden Ansprüche, insbesondere nach Anspruch 11,
**dadurch gekennzeichnet, dass**
das Querverbindungselement (33, 34) mindestens ein erstes Abstützelement (35, 35') aufweist, vorzugsweise ein Punktstützenelement, insbesondere vorzugsweise ein Kugelelement, so dass die Mehrschichtkörper (40, 50) auf dem oder an dem Querverbindungselement (33, 34) über das Abstützelement (35, 35') auflegbar oder anlegbar sind,
wobei das Abstützelement (35, 35') derart ausgebildet ist, dass es dieselbe Höhe wie das jeweilige mindestens eine Rahmenelement und/oder die Rahmenleistenelemente (131a, 131c, 231a, 231c, 331a, 331c, 431a, 431c, 631a, 631c, 731a, 731c, 632a, 632c, 732a, 732c) aufweist.

13. Vorrichtung nach einem der vorhergehenden Ansprüche,
**dadurch gekennzeichnet, dass**
diese mindestens ein zweites Abstützelement (36, 36') aufweist, vorzugsweise ein Punktstützenelement, insbesondere vorzugsweise ein Kugelelement, das am Kammerboden (16) der Prozesskammer (11) und/oder am Bodenelement (23) der Prozessbox (20a) zum Abstützen der Mehrschichtkörperanordnung (28a bis 28g) vorgesehen ist.

14. Vorrichtung nach einem der vorhergehenden Ansprüche, insbesondere nach einem der Ansprüche 9 bis 13,
**dadurch gekennzeichnet, dass**
das jeweilige Rahmenelement und/oder Rahmenleistenelement (131a, 131c, 231a, 231c, 331a, 331c, 431a, 431c, 631a, 631c, 731a, 731c, 632a, 632c, 732a, 732c) mindestens zwei Abstützelemente (35, 35') derart aufweist, dass die Mehrschichtkörper (40, 50) auf den oder an den Abstützelementen (35, 35') auflegbar oder anlegbar sind.

15. Mehrschichtkörperanordnung (28a bis 28g), umfassend
- mindestens zwei Mehrschichtkörper (40, 50), mit jeweils mindestens einer zu prozessierenden Oberfläche (44, 54),
- mindestens eine Vorrichtung (30a bis 30g) zum Positionieren der mindestens zwei Mehrschichtkörper (40, 50) nach einem der Ansprüche 1 bis 14.

16. Mehrschichtkörperanordnung (28a bis 28g), umfassend mindestens zwei Mehrschichtkörper (40, 50), mit jeweils mindestens einer zu prozessierenden Oberfläche (44, 54),
wobei die mindestens zwei Mehrschichtkörper (40, 50) derart angeordnet sind, dass sie sich gegenüberliegen, wobei die zu prozessierenden Oberflächen (44, 54) voneinander abgewandt sind.

17. Anlage (10) zum Prozessieren, insbesondere zum Selenisieren, von mindestens zwei Gegenständen, insbesondere von mindestens zwei Mehrschichtkörpern (40, 50), mit jeweils mindestens einer zu prozessierenden Oberfläche (44, 54), umfassend
- mindestens eine Prozesskammer (11) mit einem Kammerraum (12),
- eine Vorrichtung (30a bis 30g) zum Positionieren der mindestens zwei Gegenstände nach einem der Ansprüche 1 bis 14.

18. Anlage nach Anspruch 17,
**dadurch gekennzeichnet, dass**
diese ein Gaszufuhrelement und/oder Gasabfuhrelement zum Zuführen und/oder Abführen des Prozessgases in den und/oder aus dem Kammerraum und/oder Prozessraum aufweist.

19. Verfahren zum Positionieren von mindestens zwei Gegenständen, insbesondere von mindestens zwei Mehrschichtkörpern (40, 50) mit jeweils mindestens einer zu prozessierenden Oberfläche (44, 54),
mittels einer Vorrichtung (30a bis 30g) zum Positionieren der mindestens zwei Gegenstände, insbesondere Mehrschichtkörper, die zur Aufnahme der mindestens zwei Gegenstände, insbesondere der Mehrschichtkörper, ausgebildet ist,
wobei das Verfahren folgende Schritte umfasst:
- Anordnen der Vorrichtung (30a bis 30g) an einer dafür vorgesehenen Stelle,
- Anordnen der zwei Gegenstände, insbesondere Mehrschichtkörper (40, 50), an der Vorrichtung (30a bis 30g) derart, dass sich die Gegenstände, insbesondere Mehrschichtkörper (40, 50), gegenüberliegen, wobei die zu prozessierenden Oberflächen (44, 54) voneinander abgewandt sind, so dass die mindestens zwei Gegenstände als eine Mehrschichtkörperanordnung (28a bis 28g) in einer Prozessieranlage (10) prozessierbar, insbesondere selenisierbar sind.

20. Verfahren zum Positionieren von mindestens zwei Gegenständen, insbesondere von mindestens zwei Mehrschichtkörpern (40, 50) mit jeweils mindestens einer zu prozessierenden Oberfläche (44, 54),
wobei das Verfahren folgenden Schritt umfasst:
Anordnen der zwei Gegenstände, insbesondere der zwei Mehrschichtkörper (40, 50) derart,
dass sich die Gegenstände, insbesondere Mehrschichtkörper (40, 50), gegenüberliegen, wobei die zu prozessierenden Oberflächen (44, 54) voneinander abgewandt sind,
so dass die mindestens zwei Gegenstände als eine Mehrschichtkörperanordnung (28a, 28b, 28c, 28d, 28e, 28f, 28g) in einer Prozessieranlage (10) prozessierbar, insbesondere selenisierbar sind.
